# EUROPEAN PATENT APPLICATION

(11) **EP 3 493 435 A1**
(43) Date of publication of application: **05.06.2019**
(21) Application number: 17833531.1
(22) Date of filing: 25.07.2017
(51) Int. Cl.: H04L 1/00

(54) **ENCODING METHOD AND APPARATUS**

(30) Priority: 29.07.2016 CN 201610614102
(71) Applicant: ZTE Corporation, Shenzhen, Guangdong 518057 (CN)
(72) Inventor: YIN, Junjie, Shenzhen Guangdong 518057 (CN)
(74) Representative: Petit, Maxime
(86) International application number: PCT/CN2017/094297
(87) International publication number: WO 2018/019228

(57) **Abstract**

An encoding method and apparatus are provided, relating to the encoding technique. The encoding method includes: acquiring data to be encoded; performing linear block encoding on the data to be encoded together with data in a pre-set first-in first-out memory, called FIFO memory, to obtain a check code, wherein the FIFO memory has a depth of N, where N is an integer greater than or equal to 1; acquiring a code word to be sent according to the data to be encoded and the check code; acquiring a matrix to be processed corresponding to the code word to be sent, and storing the matrix to be processed in the FIFO memory; and performing matrix row and column transformation operation on all of the matrixes to be processed in the FIFO memory according to a predetermined mapping relationship to obtain a new matrix, wherein the matrix row and column transformation operation refers to an operation of changing position of each element in the matrix to be processed, without changing value of each element. The present disclosure is used in encoding technique.

## Description

### TECHNICAL FIELD

The present disclosure relates to communication field, specifically, relates to an encoding technique, and particularly relates to an encoding method and apparatus.

### BACKGROUND

Forward Error Correction technique, called FEC technique, is widely used in optical communication system so as to improve performance of bit error rate of the system and enhance the reliabilities of the communication system. In recent years, ITU-T launches research on FEC code with respect to the rapid development of optical communication system and puts forward several proposals related to these topics (for example, ITU-T G.707, G.975, G.709 and G.975.1). However, as optical communication system develops with more capacities and higher rates, especially, as the rate of simplex wave evolves from 40G to 100G and particularly beyond 100G, transmission effects in optical fibers (for example, chromatic dispersion, polarization mode dispersion and nonlinear effects) may have further effect on improvements of transmission rates and transmission distances. For this reason, better FEC code patterns are developed constantly to obtain higher net coding gain, called NCG, and better error correction capabilities so as to meet the need for rapid development of optical communication system.

FEC undergoes three generations from the point of view of time and performances. The first generation of FEC adopts hard-decision block code whose typical representative is RS(255,239) which is written in ITU-T G.709 and ITU-T G.975 standard and is widely used in the field of optical communication. The second generation of FEC adopts hard-decision cascade code and comprehensively uses cascade, interleaving and iterative decoding to effectively enhance error correction capabilities of FEC. ITU-T G.975.1 standard collects 8 kinds of algorithms of the second generation of FEC and may support the needs for long distant transmission of the systems with the rate of simplex wave of 10G and 40G. The third generation of FEC is soft-decision FEC whose application is possible because of the using of technique of coherent receiving and rapid development of the technique of integrated circuits as the simplex wave evolves to 100G. Soft-decision FEC adopts relatively larger structural overhead (such as, 15%-20%) of code pattern. When BER=1E-15 is output, net coding gain is approximately 11dB, which may support the needs for long distant transmission of the systems with the rate of simplex wave of 10G and 40G.

Common soft-decision FEC algorithms for optical communication include Turbo Product Code, called, TPC, and Low Density Parity Check Code, called LDPC. The Turbo Product Code is encoded to form a multi-dimensional data block through block combination for block codes. The data blocks are independent encoding-decoding units. These independent data blocks are respectively decoded by decoder in receiving terminal.

According to Shannon theorem, the more correlative among the code words, the better the corresponding encoding error correction capabilities are. Turbo Product Codes are independent code block units with finite length. Correlation among code words for Turbo Product Code is relatively week. Furthermore, According to the encoding scheme of Turbo Product Code, a deadlock structure exists because horizontally and vertically alternative BCH (abbreviation of Bose, Ray, Hocquenghem) decoding method is adopted in the decoding process. This deadlock structure makes horizontal decoding and vertical decoding unsuccessful and results in a theoretical platform of error code for Turbo Product Code.

### SUMMARY

With respect to above problems, the embodiment of the present disclosure presents a method for encoding and an apparatus so as to improve error correction capabilities.

In order to solve the problem, the present disclosure present an encoding method, including: acquiring data to be encoded; performing linear block encoding on the data to be encoded together with data in a pre-set first-in first-out memory, called a FIFO memory, to obtain a check code, wherein the FIFO memory has a depth of N, where N is an integer greater than or equal to 1; acquiring a code word to be sent according to the data to be encoded and the check code; acquiring a matrix to be processed corresponding to the code word to be sent, and storing the matrix to be processed in the FIFO memory; and performing matrix row and column transformation operation on all of the matrixes to be processed in the FIFO memory according to a predetermined mapping relationship to obtain a new matrix, wherein the matrix row and column transformation operation refers to an operation of changing position of each element in the matrix to be processed, without changing value of each element.

Performing the linear block encoding on the data to be encoded together with the data in the pre-set FIFO memory to obtain the check code includes: splicing data bit matrix corresponding to the data to be encoded with N pieces of data in the FIFO memory to form splicing bit matrix, wherein each of the N pieces of data in the FIFO memory is a square matrix; performing, if the number of columns of the splicing bit matrix is equal to a length of information bits of a pre-set linear block encoding structure, linear block encoding on the splicing bit matrix row by row to obtain a first check matrix; filling, if the number of the columns of the splicing bit matrix is less than the length of the information bits of the pre-set linear block encoding structure, the data bit matrix and splicing the filled data bit matrix with the N pieces of data in the FIFO memory to obtain information bit matrix so that the number of columns of the information bit matrix is equal to the length of the information bits; and performing linear block encoding on the information bit matrix row by row to obtain a second check matrix.

Acquiring the code word to be sent according to the data to be encoded and the check code includes: utilizing the data bit matrix and the first check matrix to compose the code word to be sent, or utilizing the data bit matrix and the second check matrix to compose the code word to be sent.

Acquiring the matrix to be processed corresponding to the code word to be sent, and storing the matrix to be processed in the FIFO memory includes: using, if the number of the columns of the splicing bit matrix is equal to the length of the information bits of the pre-set linear block encoding structure, a matrix formed of the data bit matrix and the first check matrix as the matrix to be processed, and using, if the number of the columns of the splicing bit matrix is less than the length of the information bits of the pre-set linear block encoding structure, a matrix formed of the filled data bit matrix and the second check matrix as the matrix to be processed; acquiring the number of rows and the number of columns of the matrix to be processed; and transforming, if the number of the columns of the matrix to be processed is less than the number of the rows of the matrix to be processed, the matrix to be processed into a square matrix and storing the square matrix in the FIFO memory according to a principle of first-in first-out.

Transforming the matrix to be processed into the square matrix includes: acquiring column vector of extended check bits; and filling the matrix to be processed with the column vector of the extended check bits until the number of the rows of the matrix to be processed is equal to the number of the columns of the matrix to be processed.

Performing the matrix row and column transformation operation on all of the matrixes to be processed in the FIFO memory includes: performing any one of the following matrix row and column transformation operations on all of the matrixes to be processed in the FIFO memory: cyclically shifting, beginning with a first column of the matrix to be processed, the matrix to be processed downward by predetermined bits until all of columns are shifted to form a temporary matrix to be processed, and cyclically shifting, beginning with a first row of the temporary matrix to be processed, the temporary matrix to be processed leftward by predetermined bits until all of rows are shifted to form a transformed matrix to be processed; performing transpose operation on the matrix to be processed to obtain the transformed matrix to be processed; and cyclically shifting, beginning with the first row of the matrix be processed, the matrix to be processed leftward by predetermined bits until all of rows are shifted to form the transformed matrix to be processed.

Among the matrix to be processed and N new matrixes obtained by performing the matrix row and column transformation operation on the matrix to be processed through the FIFO memory, relative position of at least two matrixes is in a relationship of transpose transformation, and the matrix to be processed is different from the N new matrixes each other, the check codes are scattered among row vectors participating in the linear block encoding according to a predetermined requirement after the matrix row and column transformation operation.

Before acquiring the data to be encoded, the method further includes: initializing data in the FIFO memory to be: all zero, or pre-set data, or data related to previous N pieces of data to be encoded.

The second aspect of this disclosure presents an encoding apparatus, including: a data acquiring module configured to acquire data to be encoded; a check code acquiring module configured to perform linear block encoding on the data to be encoded together with data in a pre-set first-in first-out memory, called a FIFO memory, to obtain a check code, wherein the FIFO memory has a depth of N, where N is an integer greater than or equal to 1; a code word to-be-sent acquiring module configured to acquire a code word to be sent according to the data to be encoded and the check code; a storing module configured to acquire a matrix to be processed corresponding to the code word to be sent and store the matrix to be processed in the FIFO memory; and a matrix transformation module configured to perform matrix row and column transformation operation on the matrix to be processed in the FIFO memory according to a predetermined mapping relationship to obtain a new matrix, wherein the matrix row and column transformation operation refers to an operation of changing position of each element in the matrix to be processed, without changing value of each element.

The check code acquiring module includes: a matrix splicing submodule configured to splice data bit matrix corresponding to the data to be encoded with the N pieces of data in the FIFO memory to form splicing bit matrix, wherein each of the N pieces of data in the FIFO memory is a square matrix; a first-check-matrix acquiring submodule configured to perform linear block encoding on the splicing bit matrix row by row to obtain a first check matrix if the number of columns of the splicing bit matrix is equal to a length of information bits of a pre-set linear block encoding structure; an information-bit-matrix acquiring submodule configured to fill the data bit matrix and splice the filled data bit matrix with the N pieces of data in the FIFO memory to obtain information bit matrix so that the number of columns of the information bit matrix is equal to the length of the information bits if the number of the columns of the splicing bit matrix is less than the length of the information bits of the pre-set linear block encoding structure; and a second-check-matrix acquiring submodule configured to perform linear block encoding on the information bit matrix row by row to obtain a second check matrix..

The code word to-be-sent acquiring module is configured to utilize the data bit matrix and the first check matrix to compose the code word to be sent, or utilize the data bit matrix and the second check matrix to compose the code word to be sent.

The storing module includes: a first matrix-to-be-processed acquiring submodule configured to use a matrix formed of the data bit matrix and the first check matrix as the matrix to be processed if the number of the columns of the splicing bit matrix is equal to the length of the information bits of the pre-set linear block encoding structure; a second matrix-to-be-processed acquiring submodule configured to use a matrix formed of the filled data bit matrix and the second check matrix as the matrix to be processed if the number of the columns of the splicing bit matrix is less than the length of the information bits of the pre-set linear block encoding structure; an information acquiring submodule configured to acquire the number of rows and the number of columns of the matrix to be processed; and a matrix processing submodule configured to transform the matrix to be processed into a square matrix and store the square matrix in the FIFO memory according to a principle of first-in first-out if the number of the columns of the matrix to be processed is less than the number of the rows of the matrix to be processed.

The matrix processing submodule is configured to acquire column vector of extended check bits; and fill the matrix to be processed with the column vector of the extended check bits until the number of the rows of the matrix to be processed is equal to the number of the columns of the matrix to be processed.

The matrix transformation module is configured to perform any one of the following matrix row and column transformation operations on the matrixes to be processed: cyclically shifting, beginning with a first column of the matrix to be processed, the matrix to be processed downward any bits until all of columns are shifted to form a temporary matrix to be processed, and cyclically shifting, beginning with a first row of the temporary matrix to be processed, the temporary matrix to be processed leftward any bits until all of rows are shifted to form a transformed matrix to be processed; performing transpose operation on the matrix to be processed to obtain the transformed matrix to be processed; and cyclically shifting, beginning with the first row of the matrix be processed, the matrix to be processed leftward any bits until all of rows are shifted to form the transformed matrix to be processed.

The apparatus further includes: an initializing module configured to initialize data in the FIFO memory to be: all zero, or pre-set data, or data related to previous N pieces of data to be encoded.

The above technical solutions of the present disclosure have following beneficial effects.

In the embodiments of the present disclosure, when data to be encoded is encoded, data to be encoded is encoded together with data in FIFO memory so that correlation among the structures of neighboring code patterns is enhanced and the effect is equivalent to increase the length of code. In addition, in the embodiments of the present disclosure, matrix row and column transformation operations are performed on matrix to be processed in FIFO memory according to the predetermined mapping relationships so that the positions of all elements in the matrix to be processed are changed. Therefore, the embodiment of the present disclosure utilizes the BCH decoding procedure in inclined direction in addition to decoding method of the horizontal and vertical alternative decoding of TPC so that deadlock structure in Turbo Product Code is broken so as to obtain better platform of bit error. Therefore, the embodiments of the present disclosure improve the error correction capabilities when encoding.

### BRIEF DESCRIPTION OF THE DRAWINGS

The described drawings which constitute a portion of the disclosure are used to provide further understanding of this disclosure. The schematic embodiments and the description thereof are used to explain this disclosure and do not restrict its scope, in the drawings:
Fig. 1 is a flowchart of the encoding method of a first embodiment of the present disclosure;
Fig. 2 is a flowchart of the encoding method of a second embodiment of the present disclosure;
Fig. 3 is a diagram of matrix transformation of the second embodiment of the present disclosure;
Fig. 4 is a diagram of matrix transformation of a third embodiment of the present disclosure;
Fig. 5 is a flowchart of the encoding method of the third embodiment of the present disclosure;
Fig. 6 is a diagram of matrix transformation of a fourth embodiment of the present disclosure;
Fig. 7 is a flowchart of the encoding method of the fourth embodiment of the present disclosure;
Fig. 8 is a diagram of the encoding apparatus of a fifth embodiment of the present disclosure; and
Fig. 9 is a structural chart of the encoding apparatus of the fifth embodiment of the present disclosure.

### DETAILED DESCRIPTION

The embodiments of the present disclosure are further described in combination with drawings and examples. The following examples are used to illustrate the present disclosure and do not restrict its scope.

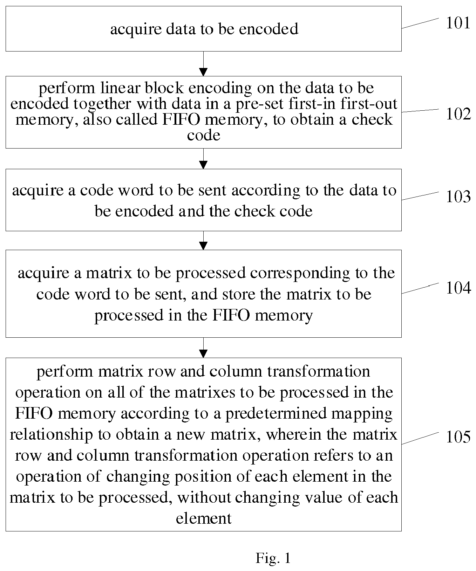

As illustrated in Fig. 1, the encoding method of the first embodiment of the present disclosure includes step 101- step 104.

At step 101, data to be encoded is acquired.

At step 102, linear block encoding is performed on the data to be encoded together with data in a pre-set first-in first-out memory, called a FIFO memory, to obtain a check code.

The FIFO memory has a depth of N, where N is an integer greater than or equal to 1; wherein each data in the FIFO memory is a square matrix.

When the method of the present disclosure is performed at the first time, data in the FIFO memory may be initialized to be: all zero, or the pre-set data prescribed at other transceiver terminals. When the embodiment of the present disclosure is performed subsequently, the data which is correlative with the data to be encoded last time or last several times is still stored in FIFO memory, i.e. the results obtained last time or last several times based on the embodiment of the present disclosure (steps 101-105) are still stored in FIFO memory. That is, the processed results obtained based on the solution of the embodiment of the present disclosure are stored in FIFO memory according to the order of first-in first-out and used as parameters for the solution of based on the embodiment of the present disclosure implemented next time.

The step includes the following steps (1)-(3).

Step (1) includes splicing the data bit matrix corresponding to the data to be encoded with the N pieces of data in the FIFO memory to form a splicing bit matrix.

Step (2) includes if the number of columns of the splicing bit matrix is equal to a length of information bits of a pre-set linear block encoding structure, performing linear block encoding on the splicing bit matrix row by row to obtain a first check matrix.

Step (3) includes if the number of the columns of the splicing bit matrix is less than the length of the information bits of the pre-set linear block encoding structure, filling the data bit matrix and splicing the filled data bit matrix with the N pieces of data in the FIFO memory to obtain information bit matrix so that the number of columns of the information bit matrix is equal to the length of the information bits; and performing linear block encoding on the information bit matrix row by row to obtain a second check matrix.

At step 103, the code word to be sent is acquired according to the data to be encoded and the check code.

Based on the results of step 102, in this step 103, the data bit matrix and the first check matrix are utilized to compose the code word to be sent, or the data bit matrix and the second check matrix are utilized to compose the code word to be sent.

At step 104, the matrix to be processed corresponding to the code word to be sent is acquired, and the matrix to be processed is stored in the FIFO memory.

In the specific application, the step 104 includes the following steps (1)-(3).

Step (1) includes if the number of the columns of the splicing bit matrix is equal to the length of the information bits of the pre-set linear block encoding structure, a matrix formed of the data bit matrix and the first check matrix is used as the matrix to be processed, if the number of the columns of the splicing bit matrix is less than the length of the information bits of the pre-set linear block encoding structure, a matrix formed of the filled data bit matrix and the second check matrix is used as the matrix to be processed.

Step (2) includes acquiring the number of rows and the number of columns of the matrix to be processed.

Step (3) includes if the number of the columns of the matrix to be processed is less than the number of the rows of the matrix to be processed, transforming the matrix to be processed into a square matrix and storing the square matrix in the FIFO memory according to a principle of first-in first-out. In the operation of transforming the matrix to be processed into the square matrix including, column vector of extended check bits is acquired; and the matrix to be processed is filed with the column vector of the extended check bits until the number of the rows of the matrix to be processed is equal to the number of the columns of the matrix to be processed.

At step 105, the matrix row and column transformation operation is performed on the matrix to be processed in the FIFO memory according to a predetermined mapping relationship, to obtain a new matrix. The matrix row and column transformation operation refers to an operation of changing the position of each element in the matrix to be processed, without changing the value of each element.

When the matrix row and column transformation operation is performed, any one scheme of the following matrix row and column transformations is performed on the matrix to be processed in FIFO memory.

A first scheme includes cyclically shifting, beginning with a first column of the matrix to be processed, the matrix to be processed downward by predetermined bits until all of columns are shifted to form a temporary matrix to be processed, and cyclically shifting, beginning with a first row of the temporary matrix to be processed, the temporary matrix to be processed leftward by predetermined bits until all of rows are shifted to form a transformed matrix to be processed.

A second scheme includes: performing transpose operation on the matrix to be processed to obtain the transformed matrix to be processed.

A third scheme 3 includes: cyclically shifting, beginning with the first row of the matrix be processed, the matrix to be processed leftward by predetermined bits until all of rows are shifted to form the transformed matrix to be processed.

Data to be encoded which will be obtained next may be processed according to the above schemes.

As can be seen, in the embodiments of the present disclosure, when data to be encoded is encoded, data to be encoded is encoded together with data in FIFO memory so that correlation among the structures of neighboring code patterns is enhanced and the effect is equivalent to increase the length of code. In addition, in the embodiments of the present disclosure, matrix row and column transformation operations are performed on matrix to be processed in FIFO memory according to a predetermined mapping relationship so that the positions of various elements in the matrix to be processed are changed. Therefore, the embodiment of the present disclosure utilizes the BCH decoding procedure in inclined direction in addition to decoding method of the horizontal and vertical alternative decoding of TPC so that deadlock structure in Turbo Product Code is broken so as to obtain better platform of bit error. Therefore, the embodiment of the present disclosure improves the error correction capabilities when encoding.

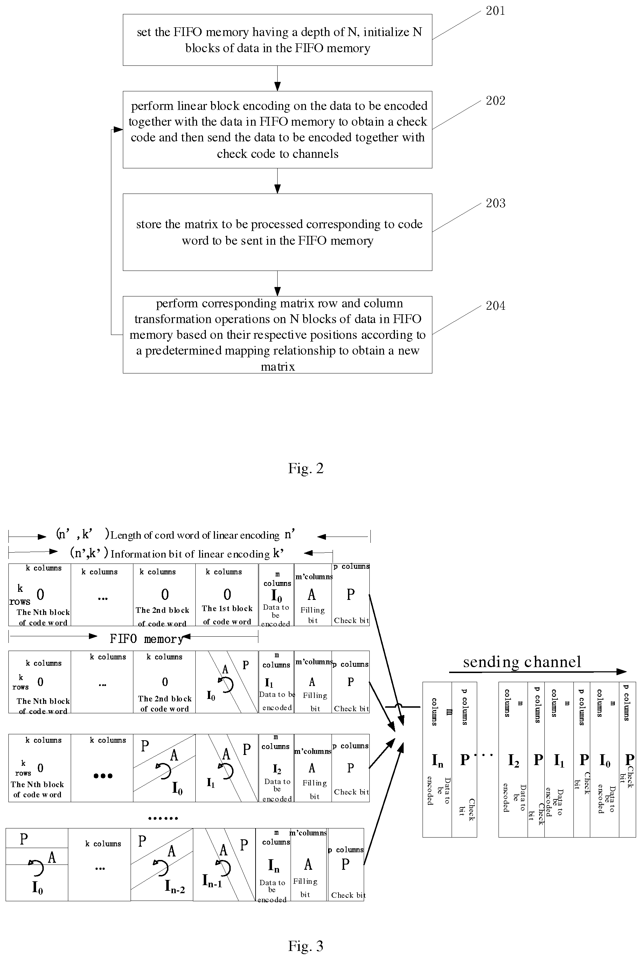

As illustrated in Fig. 2, the encoding method of the second embodiment of the present disclosure includes the following step 201-step 204.

At step 201, a FIFO memory having a depth of N is set, and N blocks of data in the FIFO memory is initialized.

The depth N of the FIFO memory is an integer which is larger than or equal to 1, the N blocks of data may be initialized to be: all zero, or pre-set data prescribed by other transceiver terminals. The N blocks of data in the FIFO memory are arranged in squares. Here, each block of data is assumed as a square matrix of k×k. After the initialization of the FIFO memory is completed, the copies of code words sent to receiver terminal previous N times are stored sequentially according to the principles of first-in first-out.

At step 202, linear block encoding is performed on the data to be encoded together with the data in the pre-set first-in first-out memory, called a FIFO memory, to obtain a check code, and then the data to be encoded is sent together with the check code to channels.

For this purpose, as illustrated in Fig. 3, the data to be encoded is assumed as I matrix (which are sequentially marked as 10, I1, I2 ..., In in the order sent in Fig. 3), I is a data bit matrix of k rows×m columns (m<k). Data bit matrix I and N pieces of data in FIFO memory are spliced together to form a splicing bit matrix of k rows × (N × k+m) columns which is information bit data of linear block encoding.

Assuming that the linear block encoding structure adopted is (n', k'), wherein k' is the length of information bits, n' is the length of code words. If the number of columns (N×k+m) of the splicing bit matrix which is spliced from data bit matrix I and N pieces of data is less than k' , m' columns of information filling bits A which are prescribed at transceiver are added to I matrix corresponding to data to be encoded until the number of columns (N×k+m+m') of bit matrix formed of matrix N adding matrix I and A is equal to k'. Then the obtained matrix is called information bit matrix. Then the information bit matrix is encoded. If the number of columns (N×k+m) of splicing bit matrix which is spliced from data bit matrix I and N pieces of data is equal to k' , the splicing bit matrix is directly utilized to implement the succeeding encoding.

If the number of columns (N×k+m) of splicing bit matrix which is spliced from data bit matrix I and N pieces of data is less than k' , linear block encoding is performed on the information bit matrix of k rows×k' columns row by row so as to obtain a matrix of k rows×(k'+p) columns, wherein p columns is the length of parity. Here, newly added matrix of k rows×p columns which is obtained through linear block encoding is assumed as check matrix P. Then code word to be sent is matrix I corresponding to data to be encoded adding the check matrix P. Therefore, the code word of total k rows×(m+p) columns to be sent is obtained.

If the number of columns (N×k+m) of splicing bit matrix which is spliced from data bit matrix I and N pieces of data is equal to k' , linear block encoding is performed on the splicing bit matrix row by row so as to obtain the check matrix. Here the code word to be sent is matrix I corresponding to data to be encoded adding check matrix P.

The result of matrix I adding matrix P is used as code word to be sent and is sent to channels.

At step 203, matrix to be processed corresponding to the code word to be sent is stored in the FIFO memory.

The data in the FIFO memory is stored according to the principle of first-in first-out.

In this step 203, matrix to be processed corresponding to code word to be sent is the sum of matrix I, information filling bit A and check matrix P, i.e., code words of whole k rows× (m+m' +p) columns are copied in FIFO memory.

If (m+m'+p) is less than k, then column vectors of extended check bits may be obtained through parity check operation on whole row vectors (length of N×k+m+m'+p) of linear block code in step 202 until the sum of the width of data bits of the matrix to be processed is equal to k. Data of square matrix of k rows×k columns is obtained through the filling.

The obtained copy of data of square matrix of k rows × k columns is written in the first position of the FIFO memory. Data at the second position to the N^{th} position in the FIFO memory is replaced with the code word at the first position to the (N-1)th position in the FIFO memory. Data at the N^{th} position of FIFO memory will be discarded.

At step 204, corresponding matrix row and column transformation operation is performed on N blocks of data in the FIFO memory based on their respective positions according to a predetermined mapping relationship to obtain new matrix.

Here the matrix transformation operation refers to an operation of changing the positions of all elements of the original matrix according to a predetermined mapping relationship and the value of each element is not changed after changing the positions. Rotating arrows in code blocks in Fig. 3 represent matrix row and column transformation operations. Here matrix transformation operations only change the positions of various elements of the original matrix according to the predetermined mapping relationship without changing the value of each element after changing the positions. Here, the matrix row and column transformation operations include all row and column transformation operations with mapping relationships which may scatter (also called interleave, disperse) matrix, and the purpose of the matrix row and column transformation operations is to break deadlock in TPC.

For the same matrix to be processed, after the matrix to be processed is produced at step 203, and the matrix to be processed is copied to the FIFO memory, going through N positions, matrix transformation operations are performed N times and N+1 forms are produced. The relative positions of at least two matrixes have the relationship of transpose transformation among the N+1 forms. In addition, after row and column transformation, the elements in matrix P are dispersed on all row vectors participated in encoding as much required according to predetermined (for example, as more as possible) requirements as possible so as to enhance the correlation among code words.

If there are new data to be encoded, the whole process from the step 202 to step 204 should be performed again.

In the embodiments of the present disclosure, when data to be encoded is encoded, data to be encoded is encoded together with data in FIFO memory so that correlation among the structures of neighboring code patterns is enhanced and the effect is equivalent to increase the length of code. In addition, in the embodiments of the present disclosure, matrix row and column transformation operations are performed on matrix to be processed in FIFO memory according to the predetermined mapping relationships so that the positions of all elements in the matrix to be processed are changed. Therefore, the embodiment of the present disclosure utilizes the BCH decoding procedure in inclined direction in addition to decoding method of the horizontal and vertical alternative decoding of TPC so that deadlock structure in Turbo Product Code is broken so as to obtain better platform of bit error. Therefore, the embodiment of the present disclosure improves the error correction capabilities when encoding.

Hereinafter, the implementing process of the embodiments of the present disclosure will be described in combination with the third embodiment and the fourth embodiment.

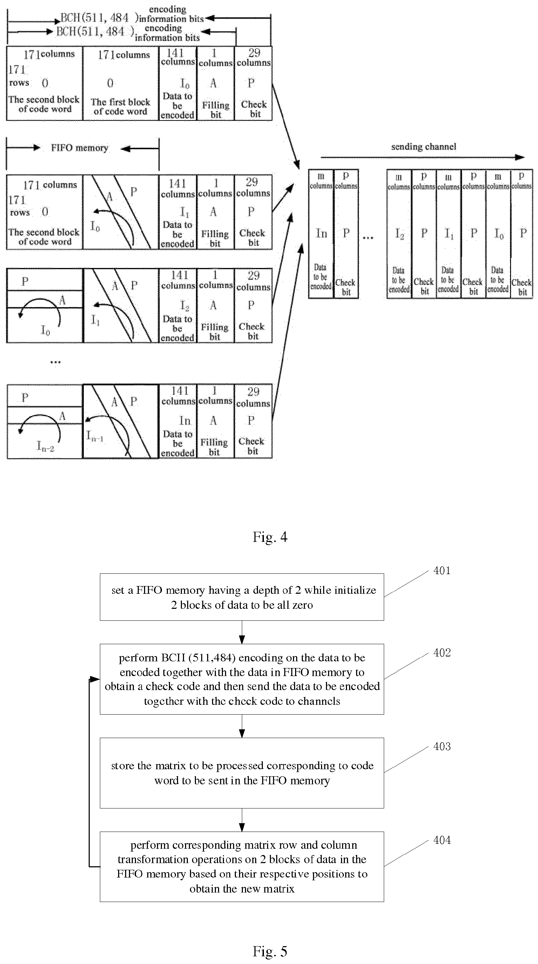

Fig. 4 is the diagram of the change of matrix of the third embodiment of the present disclosure. As illustrated in Fig. 5, the encoding method of the third embodiment of the present disclosure includes step 401 to step 404.

At step 401, the FIFO memory is set to have a depth of 2, 2 blocks of data is initialized to be all zero.

Each block of data is a square matrix of k×k. As illustrated in Fig. 4, k=513/3=171.Each piece of data in the FIFO memory is called a code word.

At step 402, BCH (511, 484) encoding is performed on the data to be encoded together with the data in FIFO memory so as to obtain a check code, and then the data to be encoded together with the check code are sent to channels.

The data to be encoded are assumed as I matrix (which is sequentially marked as 10, I1, I2 ···, in the order sent in Fig. 4), I is the data bit matrix of k×m =171 rows × (484-171×2-1) columns =171 rows×141 columns. Matrix I and 2 pieces of data are spliced together to form a splicing bit matrix of 171 rows×483 columns which is information bit data of linear block encoding.

Assuming that the linear block encoding structure adopted is BCH (511,484), Matrix I and 2 pieces of data are spliced together to form the splicing bit matrix whose number of columns is 483 which is less than 484. Here, one column of all zero or 01 alternative column is added to the rightmost side of matrix I and the one column of all zero or 01 alternative column is denoted as matrix A. Then, the number of columns of information bit matrix which is spliced by matrix I, matrix A and 2 pieces of data is 484 and then BCH (511,484) encoding is performed on the information bit matrix.

Linear block encoding is performed on the information bit matrix of 171 rows ×484 columns row by row to obtain a matrix of 171 rows ×(171×2+141+1+27) columns =171 rows ×511 columns, wherein newly added 27 columns are the length of parity. Here, newly added matrix of 171 rows ×27 columns which is obtained through linear block encoding is assumed as the check matrix P. Then code word to be sent is matrix I adding check matrix P. Therefore, code word to be sent of total 171 rows×(141+27) columns =171 rows×168 columns is obtained.

The result of matrix P adding matrix I is used as code word to be sent and is sent to channels.

At step 403, at the same time as in step 402, matrix to be processed corresponding to the code word to be sent is stored in the FIFO memory.

The data in FIFO memory is stored according to the principle of first-in first-out.

Matrix I, matrix A and check matrix P are duplicated, i.e., the whole matrix of 171 rows×(141+1+27) columns =171 rows×169 columns to be processed are duplicated.

At this time, the number of columns of the matrix to be processed formed by combining matrix I, matrix A and matrix P is 169 which is less than 171. Then 2 columns of vectors of extended check bits may be obtained through parity check operation on the whole row vector (length of 2×171+141+1+27=511) of linear block code in step 402. Thus, data of square matrix of 171 rows×171 columns is obtained.

The obtained copy of data of square matrix of 171 rows×171 columns is written in the first position of FIFO memory. Previous code word at the second position in the FIFO memory is replaced with the previous copy of code word at the first position in the FIFO memory. Previous copy of code word at the second position of FIFO memory is discarded.

At step 404, after step 403 is completed, corresponding matrix row and column transformation operation is performed on 2 blocks of data in the FIFO memory based on their respective positions so as to obtain a new matrix.

In the embodiment of the present disclosure, the matrix row and column transformation operation may be performed at least through the following three schemes.

A first scheme 1 includes cyclically shifting, beginning with a first column, the first block of square matrix having initial code word downward by 1 bit (which may correspond to the cirshift operation of Matlab), cyclically shifting downward by 2 bits for the second column and cyclically shifting downward by k bits for the kth column until the square matrix is shifted cyclically for all columns so as to form a new temporary matrix having code word. Then, the new temporary matrix having code word is cyclically shifted leftward by 1 bit beginning with the first row (which may correspond to the cirshift operation of Matlab), cyclically shifting leftward by 2 bits for the second row and cyclically shifting leftward by k bits for the kth row until the square temporary matrix is shifted cyclically for all rows so as to form a first new block of code word matrix of the FIFO memory. Transpose operation is performed on the second block of code word matrix on the basis of the second block of initial code word matrix to generate a second new block of code word matrix of the FIFO memory.

A second scheme includes cyclically shifting, beginning with a first row, the first block of square matrix having initial code word leftward by 1 bit (which may correspond to the cirshift operation of Matlab), cyclically shifting leftward by 2 bits for the second row and cyclically shifting leftward by k bits for the kth row until the square matrix is shifted cyclically for all rows so as to form a first new block of code word matrix of the FIFO memory. Transpose operation is performed on the second block of code word matrix based on the the second block of initial code word matrix to generate the second new block of code word matrix in FIFO memory.

A third scheme, in which transpose operation is performed on the first block of code word matrix based on the first block of initial code word matrix to generate the first new code word matrix in FIFO memory. The second block of square matrix having initial code word is cyclically shifted leftward by 1 bit beginning with a first row (which may correspond to the cirshift operation of Matlab), cyclically shifting leftward by 2 bits for the second row and cyclically shifting leftward by k bits for the kth row until the square matrix is shifted cyclically for all rows so as to form a second new block of code word matrix of the FIFO memory.

In the above 3 schemes, correlation obtained in matrix row and column transformation operations using the first scheme is better.

Rotating arrows in code blocks in Fig. 4 represent matrix row and column transformation operations. Here matrix transformation operations only change the positions of various elements of the original matrix according to the predetermined mapping relationship without changing the value of each element after changing the positions. Here, the matrix row and column transformation operations include all row and column transformation operations which may scatter matrix, and the purpose of the matrix row and column transformation operations is to break deadlock in TPC.

For the same matrix to be processed, after the matrix to be processed is produced at step 403 and is copied to FIFO memory, going through 2 positions in the FIFO memory, matrix transformation operations are performed 2 times and code word having 3 forms is produced and the relative position of two code words of these 3 code words has the relationship of transpose transformation. The two code words are code word matrixes after the matrix transformation of the copies of sent code words generated at step 403 and the second position in FIFO memory. In addition, the elements in matrix P are dispersed on all row vectors participated in encoding as much as possible after row and column transformation operations so as to enhance the correlation among code words.

If there is new data to be encoded, the whole process from the step 402 to step 404 should be performed again.

On one hand, the code words generated through the above-mentioned method encode neighboring code words together so that correlation among the structures of neighboring code patterns is enhanced and the effect is equivalent to increase the length of code. On the other hand, the structure of code patterns utilizes the BCH decoding procedure in inclined direction in addition to decoding method of the horizontal and vertical alternative decoding of TPC so that deadlock structure in Turbo Product Code is broken so as to obtain better platform of bit error. When decoding is implemented at receiving terminal, 3 blocks of code words need to be received consecutively before decoding is implemented. Receiving terminal may use the same FIFO storing mechanism to update decoding newly received code words. in addition, operate on received filling column vector of code word and extended column vectors should keep consistent with sending terminal according to prescribing.

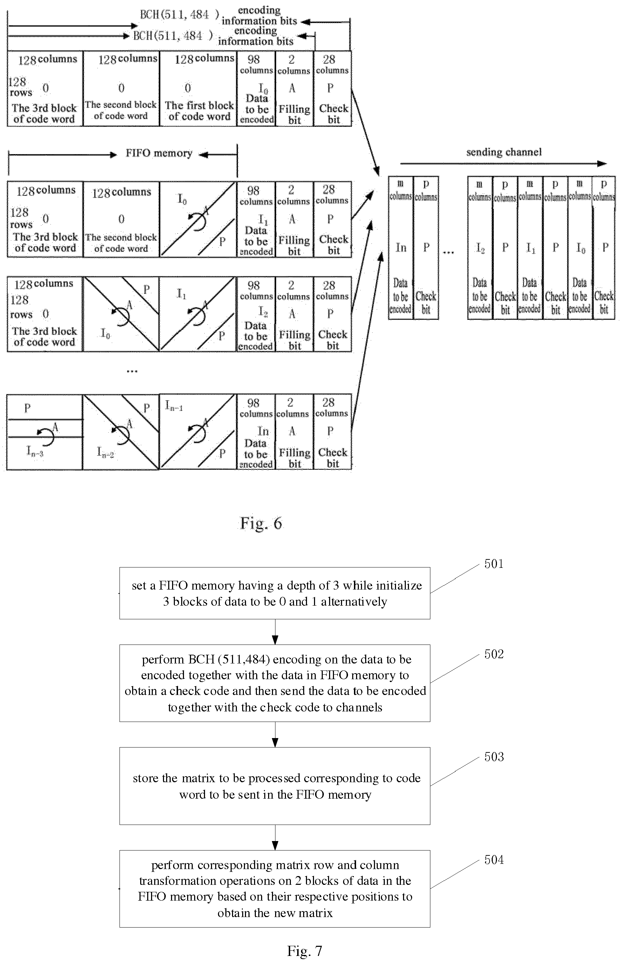

Fig. 6 is the diagram of the change of matrix of the fourth embodiment of the present disclosure. As illustrated in Fig. 7, the encoding method of the fourth embodiment of the present disclosure includes step 501 to step 504.

At step 501, the FIFO memory is set to have a depth of 3, 2 blocks of data is initialized to be alternative 0 and 1.

Each block of data is a square matrix of k×k. As illustrated in Fig. 6, k=512/4=128.

At step 502, BCH (511, 484) encoding is performed on the data to be encoded together with the data in FIFO memory so as to obtain a check code, and then the data to be encoded together with the check code are sent to channels.

The data to be encoded are assumed as matrix I (which is sequentially marked as 10, I1, I2 ···, In in the order sent in Fig. 6), I is the data bit matrix of k×m =128 rows ×(484-128×3-2) columns =128 rows×98 columns. Matrix I and 3 pieces of data are spliced together to form a splicing bit matrix of 128 rows×482 columns which is information bit data of linear block encoding.

Here the linear block encoding structure adopted is BCH (511,484), Matrix I and 3 pieces of data are spliced together to form the splicing bit matrix whose number of columns is 482 which is less than 484. Here, two columns of all zero or two 01 alternative columns are added to the rightmost side of matrix I and the two columns of all zero or two 01 alternative columns are denoted as matrix A. Then, the number of columns of information bit matrix which is spliced by matrix I, matrix A and 3 pieces of data is 484 and then BCH (511,484) encoding is performed on the information bit matrix.

Linear block encoding is performed on the information bit matrix of 128 rows ×484 columns row by row to obtain a matrix of 128 rows×(128×3+98+2+27) columns =171 rows×511 columns, wherein newly added 27 columns are the length of parity. Here, newly added matrix of 128 rows×27 columns which is obtained through linear block encoding is assumed as the check matrix P. Then code word to be sent is matrix I adding check matrix P. Therefore, code word to be sent of total 128 rows×(98+27) columns =128 rows×125 columns is obtained.

The code word to be sent obtained by combining matrix P and matrix I is sent to channels.

At step 503, at the same time as in step 502, matrix to be processed corresponding to the code word to be sent is stored in the FIFO memory.

The data in FIFO memory is stored according to the principle of first-in first-out.

Matrix I, matrix A and check matrix P are duplicated, i.e., the whole matrix of 128 rows×(98+2+27) columns =128 rows×127 columns to be processed are duplicated.

At this time, the number of columns of the matrix to be processed formed by combining matrix I, matrix A and matrix P is 127 which is less than 128. Then 1 column of vectors of extended check bits may be obtained through parity check operation on the whole row vector (length of 2×128+98+2+27=511) of linear block code in step 502. Thus, data of square matrix of 128 rows×128 columns is obtained.

The obtained copy of data of square matrix of 128 rows×128 columns is written in the first position of FIFO memory. Previous code word at the second position in the FIFO memory is replaced with the previous copy of code word at the first position in the FIFO memory. Previous code word at the third position in the FIFO memory is replaced with the previous copy of code word at the second position in the FIFO memory. Previous copy of code word at the third position of FIFO memory is discarded.

At step 504, after step 503 is completed, corresponding matrix row and column transformation operation is performed on 3 blocks of data in the FIFO memory based on their respective positions so as to obtain a new matrix.

Specifically, the first block of square matrix having initial code word is shifted cyclically rightward by 2 bits beginning with a first row (which may correspond to the cirshift operation of Matlab), cyclically shifting rightward by 4 bits for the second row and cyclically shifting rightward by k×2 bits for the kth row until the square matrix is shifted cyclically for all rows so as to form a new code word matrix. Transpose operate is performed on the second block of code word matrix based on the second block of initial word code matrix of the to generate a new matrix. The third initial code word matrix having a square shape is shifted cyclically rightward by 2 bits beginning with a first row (which may correspond to the cirshift operation of Matlab), cyclically shifting rightward by 4 bits for the second row and cyclically shifting rightward by k+2 bits for the kth row until the square matrix is shifted cyclically for all rows to form a third new block of code word matrix, that is, The second block of code word matrix may generate a third block new code word matrix based on the second block of initial word code matrix.

Rotating arrows in code blocks in Fig. 6 represent matrix row and column transformation operations. Here matrix transformation operations only change the positions of various elements of the original matrix according to the predetermined mapping relationship without changing the value of each element after changing the positions. Here, the matrix row and column transformation operations include all row and column transformation operations which may scatter matrix, and the purpose of the matrix row and column transformation operations is to break deadlock in TPC.

For the same matrix to be processed, after the matrix to be processed is produced at step 503 and is copied to FIFO memory, going through 3 positions in the FIFO memory, matrix transformation operations are performed 3 times and code word having 4 forms is produced and the relative position of two code words of these 4 code words has the relationship of transpose transformation. The two code words are code word matrixes after the matrix transformation on the first position in FIFO memory and the second position in FIFO memory respectively. In addition, the elements in matrix P are dispersed on all row vectors participated in encoding as much as possible after row and column transformation operations so as to enhance the correlation among code words.

If there is new data to be encoded, the whole process from the step 502 to step 504 should be performed again.

On one hand, the code words generated through the above-mentioned method encode neighboring code words together so that correlation among the structures of neighboring code patterns is enhanced and the effect is equivalent to increase the length of code. On the other hand, the structure of code patterns utilizes the BCH decoding procedure in inclined direction in addition to decoding method of the horizontal and vertical alternative decoding of TPC so that deadlock structure in Turbo Product Code is broken so as to obtain better platform of bit error. When decoding is implemented at receiving terminal, 4 blocks of code words need to be received consecutively before decoding is implemented. Receiving terminal may use the same FIFO storing mechanism to update decoding newly received code words. in addition, operate on received filling column vector of code word and extended column vectors should keep consistent with sending terminal according to prescribing.

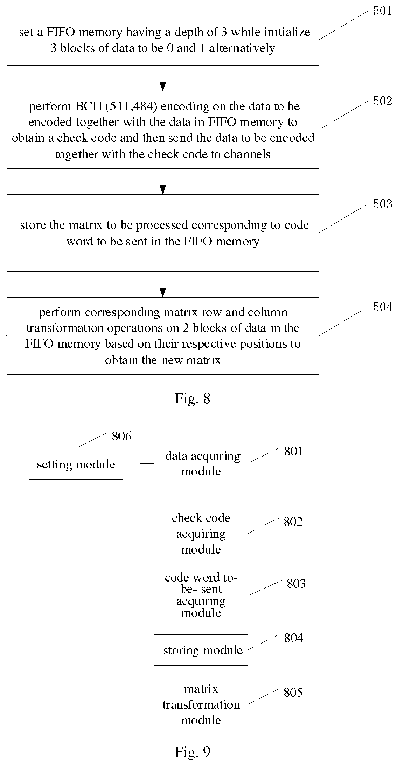

As illustrated in Fig. 8, the encoding apparatus of the fifth embodiment of the present disclosure include: a data acquiring module 801, a check code acquiring module 802, a code word to-be-sent acquiring module 803, a storing module 804 and a matrix transformation module 805.

The data acquiring module 801 is configured to acquire data to be encoded.

The check code acquiring module 802 configured to perform linear block encoding on the data to be encoded together with data in a pre-set FIFO memory to obtain a check code, wherein the FIFO memory has a depth of N, where N is an integer greater than or equal to 1.

The code word to-be-sent acquiring module 803 configured to acquire a code word to be sent according to the data to be encoded and the check code.

The storing module 804 configured to acquire a matrix to be processed corresponding to the code word to be sent and store the matrix to be processed in the FIFO memory.

The matrix transformation module 805 configured to perform matrix row and column transformation operation on the matrix to be processed in the FIFO memory according to a predetermined mapping relationship to obtain a new matrix, wherein the matrix row and column transformation operation refers to an operation of changing position of each element in the matrix to be processed, without changing value of each element.

The check code acquiring module includes: a matrix splicing submodule, a first-check-matrix acquiring submodule, an information-bit-matrix acquiring submodule and a second-check-matrix acquiring submodule.

The matrix splicing submodule is configured to splice data bit matrix corresponding to the data to be encoded with the N pieces of data in the FIFO memory to form splicing bit matrix, wherein each of the N pieces of data in the FIFO memory is a square matrix.

The first-check-matrix acquiring submodule is configured to perform linear block encoding on the splicing bit matrix row by row to obtain a first check matrix if the number of columns of the splicing bit matrix is equal to a length of information bits of a pre-set linear block encoding structure.

The information-bit-matrix acquiring submodule is configured to fill the data bit matrix and splice the filled data bit matrix with the N pieces of data in the FIFO memory to obtain information bit matrix so that the number of columns of the information bit matrix is equal to the length of the information bits if the number of the columns of the splicing bit matrix is less than the length of the information bits of the pre-set linear block encoding structure.

The second-check-matrix acquiring submodule is configured to perform linear block encoding on the information bit matrix row by row to obtain a second check matrix.

The code word to-be-sent acquiring module 803 is configured to utilize the data bit matrix and the first check matrix to compose the code word to be sent, or utilize the data bit matrix and the second check matrix to compose the code word to be sent.

The storing module 804 includes: a first matrix-to-be-processed acquiring submodule, a second matrix-to-be-processed acquiring submodule, an information acquiring submodule, and a matrix processing submodule.

The first matrix-to-be-processed acquiring submodule is configured to use a matrix formed of the data bit matrix and the first check matrix as the matrix to be processed if the number of the columns of the splicing bit matrix is equal to the length of the information bits of the pre-set linear block encoding structure.

The second matrix-to-be-processed acquiring submodule is configured to use a matrix formed of the filled data bit matrix and the second check matrix as the matrix to be processed if the number of the columns of the splicing bit matrix is less than the length of the information bits of the pre-set linear block encoding structure.

The information acquiring submodule is configured to acquire the number of rows and the number of columns of the matrix to be processed.

The matrix processing submodule is configured to transform the matrix to be processed into a square matrix and store the square matrix in the FIFO memory according to a principle of first-in first-out if the number of the columns of the matrix to be processed is less than the number of the rows of the matrix to be processed.

The matrix processing submodule is configured to acquire column vector of extended check bits; and fill the matrix to be processed with the column vector of the extended check bits until the number of the rows of the matrix to be processed is equal to the number of the columns of the matrix to be processed.

The matrix transformation module 805 is configured to perform any one of the following matrix row and column transformation operations on the matrixes to be processed:(1) cyclically shifting, beginning with a first column of the matrix to be processed, the matrix to be processed downward by any bits until all of columns are shifted to form a temporary matrix to be processed, and cyclically shifting, beginning with a first row of the temporary matrix to be processed, the temporary matrix to be processed leftward by any bits until all of rows are shifted to form a transformed matrix to be processed; (2) performing transpose operation on the matrix to be processed to obtain the transformed matrix to be processed; and(3) cyclically shifting, beginning with the first row of the matrix be processed, the matrix to be processed leftward by any bits until all of rows are shifted to form the transformed matrix to be processed.

As shown in Fig.9, in order to improve the encoding efficiency, the apparatus further includes: initializing module 806 configured to initialize data in the FIFO memory to be: all zero, or pre-set data, or data related to previous N pieces of data to be encoded.

The operating principles of the apparatus of the present disclosure may refer to the description in the embodiment for method.

In the embodiments of the present disclosure, when data to be encoded is encoded, data to be encoded is encoded together with data in FIFO memory so that correlation among the structures of neighboring code patterns is enhanced and the effect is equivalent to increase the length of code. In addition, in the embodiments of the present disclosure, matrix row and column transformation operations are performed on matrix to be processed in FIFO memory according to the predetermined mapping relationships so that the positions of all elements in the matrix to be processed are changed. Therefore, the embodiment of the present disclosure utilizes the BCH decoding procedure in inclined direction in addition to decoding method of the horizontal and vertical alternative decoding of TPC so that deadlock structure in Turbo Product Code is broken so as to obtain better platform of bit error. Therefore, the embodiment of the present disclosure improves the error correction capabilities when encoding.

The above descriptions are optional embodiments of the present disclosure. For those skilled in the art, improvements and embellishment may be made within said principles of the present disclosure. These improvements and embellishment should be regarded as within the scope of this disclosure.

### Industrial applicability

In the embodiments of the present disclosure, when data to be encoded is encoded, data to be encoded is encoded together with data in FIFO memory so that correlation among the structures of neighboring code patterns is enhanced and the effect is equivalent to increase the length of code. In addition, in the embodiments of the present disclosure, matrix row and column transformation operations are performed on matrix to be processed in FIFO memory according to the predetermined mapping relationships so that the positions of all elements in the matrix to be processed are changed. Therefore, the embodiment of the present disclosure utilizes the BCH decoding procedure in inclined direction in addition to decoding method of the horizontal and vertical alternative decoding of TPC so that deadlock structure in Turbo Product Code is broken so as to obtain better platform of bit error. Therefore, the embodiment of the present disclosure improves the error correction capabilities when encoding.

## Claims

1. An encoding method, comprising:
acquiring data to be encoded;
performing linear block encoding on the data to be encoded together with data in a pre-set first-in first-out memory, called FIFO memory, to obtain a check code, wherein the FIFO memory has a depth of N, where N is an integer greater than or equal to 1;
acquiring a code word to be sent according to the data to be encoded and the check code;
acquiring a matrix to be processed corresponding to the code word to be sent, and storing the matrix to be processed in the FIFO memory; and
performing matrix row and column transformation operation on all of the matrixes to be processed in the FIFO memory according to a predetermined mapping relationship to obtain a new matrix, wherein the matrix row and column transformation operation refers to an operation of changing position of each element in the matrix to be processed, without changing value of each element.

2. The method according to claim 1, wherein, the performing the linear block encoding on the data to be encoded together with the data in the pre-set FIFO memory to obtain the check code comprises:
splicing data bit matrix corresponding to the data to be encoded with N pieces of data in the FIFO memory to form splicing bit matrix, wherein each of the N pieces of data in the FIFO memory is a square matrix;
performing, if the number of columns of the splicing bit matrix is equal to a length of information bits of a pre-set linear block encoding structure, linear block encoding on the splicing bit matrix row by row to obtain a first check matrix;
filling, if the number of the columns of the splicing bit matrix is less than the length of the information bits of the pre-set linear block encoding structure, the data bit matrix and splicing the filled data bit matrix with the N pieces of data in the FIFO memory to obtain information bit matrix so that the number of columns of the information bit matrix is equal to the length of the information bits; and
performing linear block encoding on the information bit matrix row by row to obtain a second check matrix.

3. The method according to claim 2, wherein the acquiring the code word to be sent according to the data to be encoded and the check code comprises:
utilizing the data bit matrix and the first check matrix to compose the code word to be sent, or
utilizing the data bit matrix and the second check matrix to compose the code word to be sent.

4. The method according to claim 2, wherein the acquiring the matrix to be processed corresponding to the code word to be sent, and storing the matrix to be processed in the FIFO memory comprises:
using, if the number of the columns of the splicing bit matrix is equal to the length of the information bits of the pre-set linear block encoding structure, a matrix formed of the data bit matrix and the first check matrix as the matrix to be processed, and using, if the number of the columns of the splicing bit matrix is less than the length of the information bits of the pre-set linear block encoding structure, a matrix formed of the filled data bit matrix and the second check matrix as the matrix to be processed;
acquiring the number of rows and the number of columns of the matrix to be processed; and
transforming, if the number of the columns of the matrix to be processed is less than the number of the rows of the matrix to be processed, the matrix to be processed into a square matrix and storing the square matrix in the FIFO memory according to a principle of first-in first-out.

5. The method according to claim 4, wherein the transforming the matrix to be processed into the square matrix comprises:
acquiring column vector of extended check bits; and
filling the matrix to be processed with the column vector of the extended check bits until the number of the rows of the matrix to be processed is equal to the number of the columns of the matrix to be processed.

6. The method according to claim 1, wherein the performing the matrix row and column transformation operation on all of the matrixes to be processed in the FIFO memory comprises:
performing any one of the following matrix row and column transformation operations on all of the matrixes to be processed in the FIFO memory:
cyclically shifting, beginning with a first column of the matrix to be processed, the matrix to be processed downward by predetermined bits until all of columns are shifted to form a temporary matrix to be processed, and cyclically shifting, beginning with a first row of the temporary matrix to be processed, the temporary matrix to be processed leftward by predetermined bits until all of rows are shifted to form a transformed matrix to be processed;
performing transpose operation on the matrix to be processed to obtain the transformed matrix to be processed; and
cyclically shifting, beginning with the first row of the matrix be processed, the matrix to be processed leftward by predetermined bits until all of rows are shifted to form the transformed matrix to be processed.

7. The method according to claim 6, wherein among the matrix to be processed and N new matrixes obtained by performing the matrix row and column transformation operation on the matrix to be processed through the FIFO memory, relative position of at least two matrixes is in a relationship of transpose transformation, and the matrix to be processed is different from the N new matrixes
the check codes are scattered among row vectors participating in the linear block encoding according to a predetermined requirement after the matrix row and column transformation operation.

8. The method according to any one of claims 1-7, wherein before acquiring the data to be encoded, the method further comprises:
initializing data in the FIFO memory to be: all zero, or pre-set data, or data related to previous N pieces of data to be encoded.

9. An encoding apparatus, comprising:
a data acquiring module, configured to acquire data to be encoded;
a check code acquiring module, configured to perform linear block encoding on the data to be encoded together with data in a pre-set first-in first-out memory, called FIFO memory, to obtain a check code, wherein the FIFO memory has a depth of N, where N is an integer greater than or equal to 1;
an code word to-be-sent acquiring module, configured to acquire a code word to be sent according to the data to be encoded and the check code;
a storing module, configured to acquire a matrix to be processed corresponding to the code word to be sent and store the matrix to be processed in the FIFO memory; and
a matrix transformation module, configured to perform matrix row and column transformation operation on the matrix to be processed in the FIFO memory according to a predetermined mapping relationship to obtain a new matrix, wherein the matrix row and column transformation operation refers to an operation of changing position of each element in the matrix to be processed, without changing value of each element.

10. The apparatus according to claim 9, wherein the check code acquiring module comprises:
a matrix splicing submodule, configured to splice data bit matrix corresponding to the data to be encoded with the N pieces of data in the FIFO memory to form splicing bit matrix, wherein each of the N pieces of data in the FIFO memory is a square matrix;
a first-check-matrix acquiring submodule, configured to perform linear block encoding on the splicing bit matrix row by row to obtain a first check matrix if the number of columns of the splicing bit matrix is equal to a length of information bits of a pre-set linear block encoding structure;
an information-bit-matrix acquiring submodule, configured to fill, if the number of the columns of the splicing bit matrix is less than the length of the information bits of the pre-set linear block encoding structure, the data bit matrix and splice the filled data bit matrix with the N pieces of data in the FIFO memory to obtain information bit matrix, so that the number of columns of the information bit matrix is equal to the length of the information bits; and
a second-check-matrix acquiring submodule, configured to perform linear block encoding on the information bit matrix row by row to obtain a second check matrix.

11. The apparatus according to claim 9, wherein the acquiring module for code word to be sent is configured to
utilize the data bit matrix and the first check matrix to compose the code word to be sent, or
utilize the data bit matrix and the second check matrix to compose the code word to be sent.

12. The apparatus according to claim 10, wherein the storing module comprises:
a first matrix-to be-processed acquiring submodule, configured to use a matrix formed of the data bit matrix and the first check matrix as the matrix to be processed, if the number of the columns of the splicing bit matrix is equal to the length of the information bits of the pre-set linear block encoding structure;
a second matrix-to-be-processed acquiring submodule, configured to use a matrix formed of the filled data bit matrix and the second check matrix as the matrix to be processed, if the number of the columns of the splicing bit matrix is less than the length of the information bits of the pre-set linear block encoding structure;
an information acquiring submodule, configured to acquire the number of rows and the number of columns of the matrix to be processed; and
a matrix processing submodule, configured to transform the matrix to be processed into a square matrix and store the square matrix in the FIFO memory according to a principle of first-in first-out, if the number of the columns of the matrix to be processed is less than the number of the rows of the matrix to be processed.

13. The apparatus according to claim 12, wherein the matrix processing submodule is configured to
acquire column vector of extended check bits; and
fill the matrix to be processed with the column vector of the extended check bits until the number of the rows of the matrix to be processed is equal to the number of the columns of the matrix to be processed.

14. The apparatus according to claim 9, wherein the matrix transformation module is configured to perform any one of the following matrix row and column transformation operations on the matrixes to be processed:
cyclically shifting, beginning with a first column of the matrix to be processed, the matrix to be processed downward by any bits until all of columns are shifted to form a temporary matrix to be processed, and cyclically shifting, beginning with a first row of the temporary matrix to be processed, the temporary matrix to be processed leftward by any bits until all of rows are shifted to form a transformed matrix to be processed;
performing transpose operation on the matrix to be processed to obtain the transformed matrix to be processed; and
cyclically shifting, beginning with the first row of the matrix be processed, the matrix to be processed leftward by any bits until all of rows are shifted to form the transformed matrix to be processed.

15. The apparatus according to any one of claims 9-14, wherein the apparatus further comprises:
an initializing module, configured to initialize data in the FIFO memory to be: all zero, or pre-set data, or data related to previous N pieces of data to be encoded.

16. A storage medium comprising program stored therein, wherein the program implements the method of any one of claims 1 to 8 when executed.
